(19) **Europäisches Patentamt / European Patent Office / Office européen des brevets**

(11) **EP 2 860 405 B1**

(12) **FASCICULE DE BREVET EUROPEEN**

(45) Date de publication et mention de la délivrance du brevet:
**25.05.2016 Bulletin 2016/21**

(51) Int Cl.:
*F04D 29/66* (2006.01)    *F16F 15/00* (2006.01)

(21) Numéro de dépôt: **13188506.3**

(22) Date de dépôt: **14.10.2013**

(54) **Système amortisseur piézoélectrique pour rotor de turbomachine axiale**

Piezoelektrisches Dämpfungssystem für Rotor einer axialen Turbomaschine

Piezoelectric damper system for axial turbomachine rotor

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**15.04.2015 Bulletin 2015/16**

(73) Titulaires:
• **Techspace Aero S.A.**
  **4041 Herstal (Milmort) (BE)**
• **Université Libre de Bruxelles**
  **1050 Bruxelles (BE)**

(72) Inventeurs:
• **Viguié, Régis**
  **4300 Waremme (BE)**

• **Verhelst, Damien**
  **4000 Liège (BE)**
• **Preumont, André**
  **1450 Chastre (BE)**
• **Mokrani, Bilal**
  **1170 Bruxelles (BE)**
• **Bastaits, Renaud**
  **1050 Bruxelles (BE)**

(74) Mandataire: **Lecomte & Partners**
  **P.O. Box 1623**
  **1016 Luxembourg (LU)**

(56) Documents cités:
**JP-A- H0 861 295    JP-A- S6 166 544**
**US-A- 5 783 898**

## Description

### Domaine technique

L'invention a trait à un rotor de turbomachine axiale. Plus précisément, l'invention a trait à un système d'amortissement des vibrations d'un rotor de turbomachine axiale. Plus particulièrement, l'invention a trait à un système d'amortissement des vibrations des roues aubagées d'un rotor de turbomachine axiale avec un circuit électrique dissipatif.

### Technique antérieure

Lors de son fonctionnement, une turbomachine axiale est traversée par des flux annulaires hétérogènes. En effet, tout corps se trouvant dans un flux axial homogène va engendrer des variations de pressions aérodynamiques dans son entourage, rendant par conséquent le flux hétérogène. Ces corps peuvent être, entre autres, des aubes, des bras de carter, des portes de décharge variable.

Lorsqu'une aube de roue aubagée d'un rotor tourne dans un flux annulaire présentant de telles hétérogénéités circonférentielles, chaque variation brusque de pression sera vue comme une excitation ponctuelle. Le nombre d'excitations à 360° associées à une vitesse de rotation donnée résulte en une fréquence d'excitation particulière. Si celle-ci correspond à une fréquence propre du rotor, alors celui-ci entrera en résonance selon un mode de déformation particulier composé d'un certain nombre de diamètres nodaux.

Lorsque la roue aubagée rotorique entre en résonance sur un mode de déformation particulier, des niveaux vibratoires élevés se développent. Ces niveaux vibratoires seront d'autant plus élevés que le niveau d'amortissement intrinsèque de la structure est faible, par exemple, dans le cas de disques aubagés monoblocs ou de tambours aubagés monoblocs. De tels niveaux vibratoires sont à éviter car ils sont associés à des états de contraintes élevées qui réduisent de manière considérable la durée de vie en fatigue de la structure, et qui peuvent conduire à sa destruction. Dans ce contexte, l'utilisation de dispositifs amortissants peut s'avérer indispensable afin d'assurer la tenue en fatigue de la roue aubagée.

Parmi les dispositifs d'amortissement envisageables pour les roues aubagées rotoriques de turbomachine soumises à une déformée à diamètres, un système piézoélectrique shunté représente une solution intéressante. Celui-ci est constitué d'un patch piézoélectrique relié à un circuit électrique dissipatif.

Le document JP19960861295 divulgue un rotor aubagé dont les vibrations sont réduites à l'aide de patchs piézoélectriques répartis à sa périphérie. A chaque patch est associé un circuit fermé comportant une résistance dissipative. Le principe de fonctionnement réside sur l'existence de déformations à l'endroit même des patchs piézoélectriques, qui, une fois déformés, génèrent un courant dissipé par les résistances du circuit associé. Ce mode d'amortissement permet de réduire les vibrations d'un rotor et apporte une même efficacité pour chaque fréquence. Or, ce mode d'amortissement est peu efficace pour une vibration de forte amplitude. Aussi, ce système impose de doter chaque circuit fermé de composants, ce qui en augmente la masse et le coût. L'espace nécessaire pour implanter chaque circuit est pénalisant.

### Résumé de l'invention

#### Problème technique

L'invention a pour objectif de résoudre au moins un des problèmes soulevés par l'art antérieur. L'invention a pour objectif d'améliorer l'efficacité d'un système amortisseur de vibration d'un rotor de turbomachine présentant des modes à diamètre(s) stationnaires ou tournants. L'invention a également pour objectif de proposer un système amortisseur de vibration d'un rotor de turbomachine pouvant aussi bien être efficace à haute fréquence qu'à basse fréquence. L'invention a également pour objectif d'alléger un système amortisseur de vibration d'un rotor de turbomachine.

#### Solution technique

L'invention a pour objet un rotor, notamment de compresseur, comprenant un système amortisseur de vibrations qui comporte au moins un jeu de transducteurs piézoélectriques répartis circulairement sur le rotor et branchés à au moins un circuit dissipatif, remarquable en ce que les transducteurs piézoélectriques sont branchés de sorte à mutualiser le circuit dissipatif ou chacun des circuits dissipatifs avec un jeu respectif d'au moins deux transducteurs branchés en parallèle, les transducteurs du jeu ou de chacun des jeux étant répartis angulairement de manière homogène sur le rotor.

Les transducteurs piézoélectriques sont avantageusement disposés de manière à ce que chacun puisse être déformé en flexion suivant la déformation du rotor à l'emplacement du transducteur en question.

Selon un mode avantageux de l'invention, le rotor est apte à se déformer en vibration selon une déformée modale à diamètres, le nombre de transducteurs piézoélectriques du jeu ou de chaque jeu étant égal au double du nombre de diamètre(s) de la déformée modale.

Selon un mode avantageux de l'invention, la déformée modale à diamètres comprend essentiellement deux ondes de déformation orthogonales avec des diamètres nodaux, les transducteurs piézoélectriques étant répartis angulairement respectivement entre deux diamètres nodaux adjacents des deux ondes de déformation.

Par deux diamètres nodaux adjacents, on entend deux diamètres nodaux successifs des deux ondes de déformation. L'un des diamètres nodaux appartenant à l'une des deux ondes de déformation orthogonales, l'autre des diamètres nodaux appartenant à l'autre des deux ondes de déformation.

Selon un mode avantageux de l'invention, le système amortisseur comprend plusieurs jeux d'au moins deux transducteurs branchés en parallèle respectivement avec un des circuits dissipatifs, la polarité des branchements des transducteurs de chaque jeu étant telle que chacun desdits transducteurs génère dans leur circuit dissipatif respectif un courant de même signe lorsqu'ils sont déformés dans le même sens.

Selon un mode avantageux de l'invention, le système amortisseur ne comprend qu'un jeu d'au moins deux, préférentiellement au moins quatre transducteurs branchés avec le circuit dissipatif, la polarité des branchements des transducteurs du jeu étant telle que chacun desdits transducteurs génère dans ledit circuit dissipatif un courant de même signe lorsqu'ils sont déformés dans le même sens.

Selon un mode avantageux de l'invention, le système amortisseur comprend deux jeux d'au moins deux transducteurs, lesdits jeux étant décalés angulairement de manière à ce que tous les transducteurs de tous les jeux soient répartis angulairement de manière homogène sur le rotor.

Selon un mode avantageux de l'invention, le rotor est apte à se déformer en vibration selon une déformée modale à diamètres et que le système amortisseur comprend deux jeux de transducteurs piézoélectriques qui sont déphasés l'un par rapport à l'autre d'une fraction de tour égale à l'inverse du quadruple du nombre de diamètre de ladite déformée modale à diamètres.

Selon un mode avantageux de l'invention, le ou au moins un des circuits dissipatifs comprend au moins une inductance de manière à former un circuit résonant avec les transducteurs branchés en parallèle, le ou au moins un des circuits dissipatifs formant préférentiellement essentiellement un circuit électrique fermé en combinaison avec les transducteurs piézoélectriques du jeu correspondant.

Selon un mode avantageux de l'invention, le ou au moins un des circuits dissipatifs est libre d'alimentation électrique extérieure.

Selon un mode avantageux de l'invention, le rotor présente au moins une fréquence de résonance $\omega_R$, le circuit dissipatif étant un circuit amortissant, préférentiellement résonant, dont la fréquence d'amortissement $\omega_A$ est égale à la fréquence de résonance $\omega_R$ du rotor à amortir.

Selon un mode avantageux de l'invention, le rotor est un disque aubagé ou un tambour aubagé.

Selon un mode avantageux de l'invention, les aubes sont venues de matières.

Selon un mode avantageux de l'invention, l'épaisseur des transducteurs piézoélectriques représente plus de 5% de l'épaisseur des aubes, préférentiellement plus de 30%, plus préférentiellement plus de 100%.

Selon un mode avantageux de l'invention, au moins un des transducteurs piézoélectriques est disposé sur une surface cylindrique ou sur une surface perpendiculaire à l'axe de rotation du rotor, préférentiellement en dehors de la veine aérodynamique.

Selon un mode avantageux de l'invention, les transducteurs sont disposés de manière à se déformer en traction-compression résultant de mouvement de flexion du rotor, préférentiellement suivant des déformations en flexion de l'enveloppe du rotor.

L'invention a également pour objet une turbomachine comprenant un rotor, remarquable en ce que le rotor est conforme à l'invention, préférentiellement le rotor est un rotor de compresseur ou de turbine.

Selon un mode avantageux de l'invention, lors de son fonctionnement à un régime critique, le rotor vibre à une fréquence de résonance suivant un mode à diamètres, le nombre de transducteurs piézoélectriques de chaque jeu étant supérieur ou égal à deux fois le nombre de diamètres, préférentiellement égal à quatre fois le nombre de diamètres du mode de résonance.

Les transducteurs piézoélectriques sont avantageusement tous identiques.

Avantages apportés

L'invention permet d'exploiter la symétrie de déformation d'une roue aubagée rotorique sur un mode à diamètre donné. En disposant des transducteurs piézoélectriques de manière uniforme à 360° il est possible d'amortir un mode de vibration stationnaire ou tournant.

En regroupant les transducteurs piézoélectriques en deux jeux et moyennant la maîtrise de leur polarité, il devient possible de cumuler leurs capacités. La fréquence de résonance d'un circuit RLC s'exprimant par

$$\omega = \sqrt{\frac{1}{LC}},$$ la mutualisation des capacités donnera lieu à une capacité équivalente plus élevée. Dès lors, à isofréquence, la valeur d'inductance pourra être plus faible.

Les moyens dissipatifs sont mis en communs, ils servent à plusieurs transducteurs piézoélectriques. L'efficacité globale est renforcée, et les possibilités de traiter des fréquences réduites sont améliorées.

**Brève description des dessins**

La figure 1 représente une turbomachine axiale selon l'invention.
La figure 2 est une représentation du compresseur basse pression de la turbomachine de la figure 1.
La figure 3 illustre un rotor selon l'invention, déformé selon un mode à diamètres (trois dans l'exemple présenté) avec deux ondes orthogonales.

La figure 4 représente un rotor avec un système amortisseur de vibration selon l'invention.

La figure 5 trace un circuit dissipatif d'énergie électrique selon l'invention.

## Description des modes de réalisation

Dans la description qui va suivre, les termes intérieur et extérieur renvoient à un positionnement par rapport à l'axe de rotation d'une turbomachine axiale.

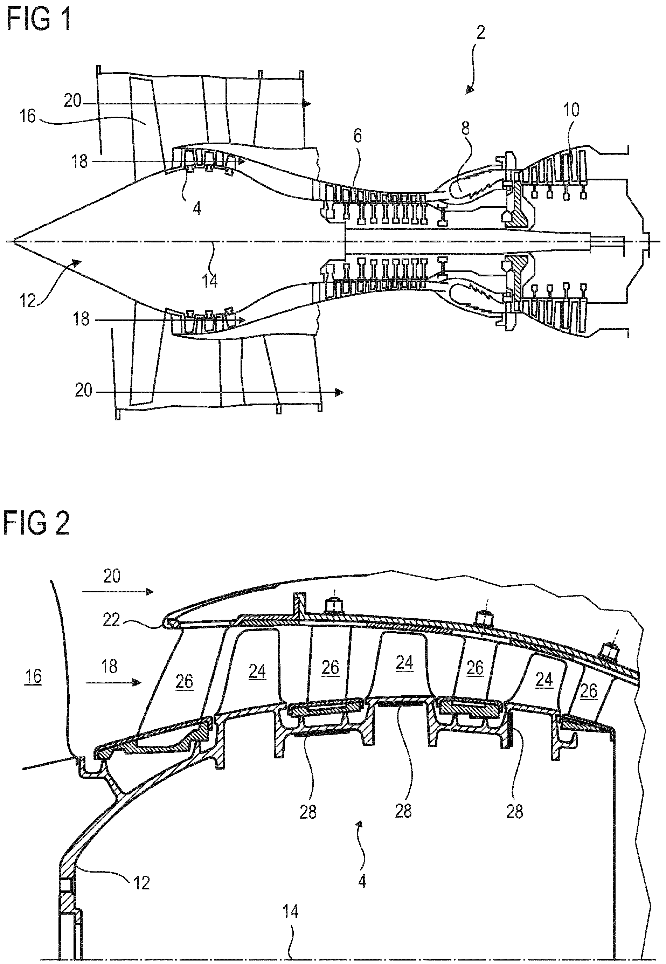

La figure 1 schématise une turbomachine axiale. Il s'agit dans ce cas précis d'un turboréacteur double-flux. Le turboréacteur 2 comprend un premier niveau de compression, dit compresseur basse-pression 4, un deuxième niveau de compression, dit compresseur haute-pression 6, une chambre de combustion 8 et un ou plusieurs niveaux de turbines 10. En fonctionnement, la puissance mécanique de la turbine 10 est transmise via l'arbre central et met en mouvement les deux compresseurs 4 et 6. Des moyens de démultiplication peuvent augmenter ou diminuer la vitesse de rotation transmise aux compresseurs. Dans un autre mode de réalisation, les différents étages de turbines peuvent chacun être reliés aux étages de compresseur via des arbres concentriques. Ces derniers comportent plusieurs roues aubagées rotoriques séparées par des roues d'aubes statoriques. La rotation des roues aubagées rotoriques autour de leur axe de rotation 14 permet ainsi de générer un débit d'air et de comprimer progressivement ce dernier jusqu'à l'entrée de la chambre de combustion 8.

Un ventilateur d'entrée communément désigné fan 16 est couplé au rotor 12 et génère un flux d'air qui se divise en un flux primaire 18 traversant les différents niveaux sus mentionnés de la turbomachine, et un flux secondaire 20 traversant un conduit annulaire (partiellement représenté) le long de la machine pour ensuite rejoindre le flux primaire en sortie de turbine. Les flux primaire 18 et secondaire 20 sont des flux annulaires, ils sont canalisés par le carter de la turbomachine.

La figure 2 est une vue en coupe d'un compresseur basse-pression 4 d'une turbomachine axiale 2 telle que celle de la figure 1. On peut y observer une partie du fan 16 et le bec de séparation 22 du flux primaire 18 et du flux secondaire 20. Le rotor 12 comprend plusieurs rangées d'aubes rotoriques 24, par exemple trois. Le compresseur basse pression 4 comprend plusieurs rangées d'aubes statoriques 26, par exemple quatre. Les redresseurs sont associés au fan 16 ou à une rangée d'aubes rotoriques pour redresser le flux d'air, de sorte à convertir la vitesse du flux en pression.

La partie rotorique du compresseur basse pression présente une forme cylindrique communément appelée tambour sur lequel les aubes rotoriques sont fixées. Il comporte une paroi extérieure essentiellement fine, son épaisseur peut être généralement inférieure à 8,00 mm, préférentiellement inférieure à 5,00 mm, encore plus préférentiellement inférieure à 3,00 mm. La paroi du rotor 12 peut présenter des surfaces structurelles s'étendant axialement et/ou radialement. Suivant une alternative de l'invention, le rotor peut avoir une forme de disque monobloc avec des aubes sur sa circonférence.

Le tambour et ses aubes peuvent être réalisés en matériau métallique tel du titane ou de l'aluminium. Ils peuvent également être réalisés en matériaux composites. Ils sont dimensionnés en tolérant certains niveaux de contraintes statiques qui peuvent être générées par les forces centrifuges, une dilatation, ou une pression. Leurs dimensionnements prennent également en compte des contraintes dynamiques générées par leurs réponses vibratoires.

En fonctionnement, le rotor 12 peut subir des excitations dynamiques, parmi lesquelles les aérodynamiques représentent la majorité. En réponse, il va vibrer. Un balourd ou un régime de fonctionnement particulier de la turbomachine peuvent être source de vibration. La structure de la turbomachine peut communiquer la vibration d'un autre organe au rotor 12.

Les vibrations du rotor s'observent entre autres sur le tambour et ses pales. Elles génèrent des déformations axiales et/ou radiales et/ou circonférentielles des parois du tambour correspondant à une composition modale particulière à une fréquence donnée. Pour un disque aubagé monobloc ou un tambour aubagé monobloc, l'amortissement structural reste très faible. Les niveaux vibratoires et donc les contraintes dynamiques associées peuvent devenir problématiques. En effet, le gain de masse impose de les amincir et donc de réduire leur résistance ainsi que leur rigidité.

Pour réduire l'amplitude de ces vibrations, le rotor 12 comprend un système amortisseur de vibrations basé sur l'utilisation de transducteurs piézoélectriques 28 associés à des moyens de dissipation d'énergie électrique. Un transducteur piézoélectrique 28 ou patch piézoélectrique est un composant comprenant un matériau piézoélectrique qui est apte à transformer une déformation en un courant électrique. Il permet donc de convertir une énergie mécanique en une énergie électrique. Il est polarisé et délivre une charge dont le signe dépend du sens de sa déformation et de son orientation. Les transducteurs piézoélectriques peuvent comprendre un matériau composite piézoélectrique, par exemple un AFC (Active Fiber Composite). Ce matériau peut être déformé de sorte à permettre le montage d'un transducteur piézoélectrique sur une surface courbe.

Afin de ne pas perturber la veine aérodynamique, les transducteurs piézoélectriques 28 ne sont pas positionnés sur les aubes mais bien sur les surfaces disponibles à l'intérieur du tambour 12, de manière uniforme à 360°. Ils peuvent être implantés sur une surface cylindrique ou une surface radiale du rotor 12. Le rotor peut présenter plusieurs ensembles de plusieurs jeux de transducteurs piézoélectriques 28 qui sont chacun répartis de manière circulaire.

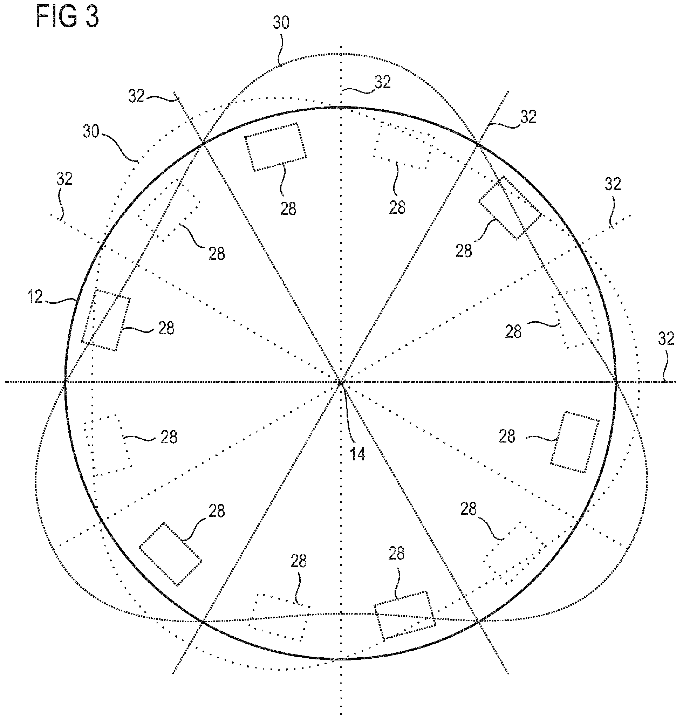

La figure 3 schématise un rotor 12 vu de face, selon l'axe 14. Cette figure présente un mode à diamètres ou déformée modale à diamètres du rotor 12 à une fré-

quence de résonance associée $\omega_R$. Cette déformée modale à diamètres présente trois diamètres. La déformée modale à diamètres comprend essentiellement deux ondes de déformation 30, chacune d'elles ayant également pour fréquence $\omega_R$. Elles sont orthogonales entre elles. Elles sont fixes par rapport au rotor 12. Les maximums d'amplitude de déformations des ondes de déformation 30 sont décalés les uns des autres. En théorie, ces maximums sont égaux. En réalité ils peuvent être différents les uns des autres. La déformée modale correspond à une combinaison linéaire des deux ondes de déformation 30 orthogonales.

La déformée modale se matérialise sur le rotor 12 par une onde vibratoire composée. En pratique l'excitation est tournante par rapport au rotor 12. La déformée modale va tourner sur le rotor 12 grâce à la combinaison des deux ondes de déformation 30 orthogonales.

En raison de la symétrie du rotor 12, le déphasage de ces ondes de déformation 30 est de 90°. Elles matérialisent chacune des changements de phase le long de la circonférence du rotor 12. Les points de changement de phase correspondent à des noeuds de vibration, où le rotor 12 ne subit aucun déplacement et aucune déformation liés à une onde de déformation donnée. Ces points sont alignés sur des diamètres, dits diamètres nodaux 32 d'ondes répartis uniformément à 360° pour un rotor 12 à symétrie cyclique. Les diamètres nodaux 32 associés à une onde de déformation 30 sont représentés avec des traits de même nature : en pointillés rapprochés pour l'une des ondes de déformation, et en pointillés écartés pour l'autre des ondes de déformation.

La déformée modale comporte également des diamètres nodaux de déformée (non représentés). Elle comporte autant de diamètre que chacune de ses déformées. Les diamètres nodaux de la déformée correspondent aux endroits où les ondes de déformation 30 s'annulent. Ces diamètres nodaux de déformée correspondent aux lieux où le rotor 12 ne subit aucune déformation. Puisque la déformée modale tourne sur le rotor, les diamètres nodaux de la déformée tourneront également.

Dans l'invention, le nombre de diamètres utilisés correspond à celui de la déformée modale. Les diamètres nodaux de la déformée modale sont ceux qui sont observés physiquement.

Sur base de calculs éléments finis et sur base de la connaissance des ordres d'excitation de la structure, les déformées modales à diamètres excitables sont identifiées. L'emplacement des diamètres nodaux 32 peuvent être déterminés, par exemple en fonction de l'emplacement des aubes rotoriques. Pour un nombre pair d'aubes et pour une déformée modale présentant un nombre de diamètre égal à la moitié du nombre d'aubes, l'emplacement des diamètres nodaux 32 sera entre les aubes. Dans ce cas, la déformée modale sera d'ailleurs stationnaire. Lorsque la déformée modale présente un nombre de diamètre(s) inférieur à la moitié du nombre d'aubes, sera tournante.

L'amortissement d'une déformée modale à diamètres peut être réalisé à l'aide d'un système amortisseur de vibrations comprenant un premier jeu de transducteurs piézoélectriques 28. Ceux-ci doivent être positionnés en fonction des diamètres nodaux 32, afin de maximiser le couplage électromécanique. Ils sont positionnés entre les diamètres nodaux 32. Ceci permet d'éviter de les annihiler puisque dans le cas contraire, deux zones d'un même transducteur piézoélectrique produiraient des charges opposées. Les zones nodales sont à éviter puisqu'elles ne se déforment pas. Le système amortisseur peut comprendre un nombre de transducteurs piézoélectriques 28 égal au double de celui des diamètres, par exemple dans le cas d'une déformée modale stationnaire.

Les transducteurs sont uniformément répartis à 360° et sont similaires. Ils décrivent un cercle concentrique au rotor 12. Dans la mesure où les ondes de déformation 30 sont déphasées, elles sont amorties essentiellement chacune à leur tour par le premier jeu de transducteurs piézoélectriques 28. L'ensemble des transducteurs piézoélectriques 28 du premier jeu s'étendent physiquement sur moins de la moitié de la circonférence.

Afin de pouvoir amortir efficacement une déformée modale tournante, le système amortisseur de vibration comprend un deuxième jeu de transducteurs piézoélectriques 28. Le deuxième jeu peut être similaire au premier jeu. Ses transducteurs piézoélectriques 28 sont disposés entre ceux du premier jeu. Les transducteurs piézoélectriques 28 des deux jeux sont avantageusement répartis uniformément sur un même cercle. Eventuellement, les deux jeux de transducteurs piézoélectriques 28 sont disposés sur des cercles décalés axialement et/ou de rayons différents. Au cumul, le système amortisseur comprend quatre fois plus de transducteurs piézoélectriques 28 que de diamètres nodaux 32 apparaissant à la fréquence de résonance $\omega R$. Un autre intérêt du deuxième jeu est qu'il permet d'éviter l'amplification d'une onde entre les transducteurs piézoélectriques 28 du premier jeu.

Alors que pour un mode stationnaire le nombre de transducteurs piézoélectriques du système amortisseur nécessaire serait le double du nombre de diamètres, pour un mode tournant il en faut quatre fois le nombre de diamètres car les deux modes orthogonaux stationnaires doivent préférentiellement être amortis.

Afin d'assurer un contrôle optimal sur les deux ondes orthogonales, les transducteurs piézoélectriques 28 ne peuvent donc être positionnés juste au maximum de déformation. Chaque transducteur piézoélectrique sera donc positionné dans chaque quadrature d'une onde de déformation. Ils occupent chacun la majorité d'une quadrature de déformation. En combinaison, les transducteurs piézoélectriques 28 des jeux décrivent matériellement plus de 20% du cercle qu'ils décrivent, préférentiellement plus de 50% ; encore plus préférentiellement plus de 90%.

Ce type d'architecture assurera, en permanence et avec la même efficacité, le contrôle des deux modes orthogonaux et donc du mode tournant.

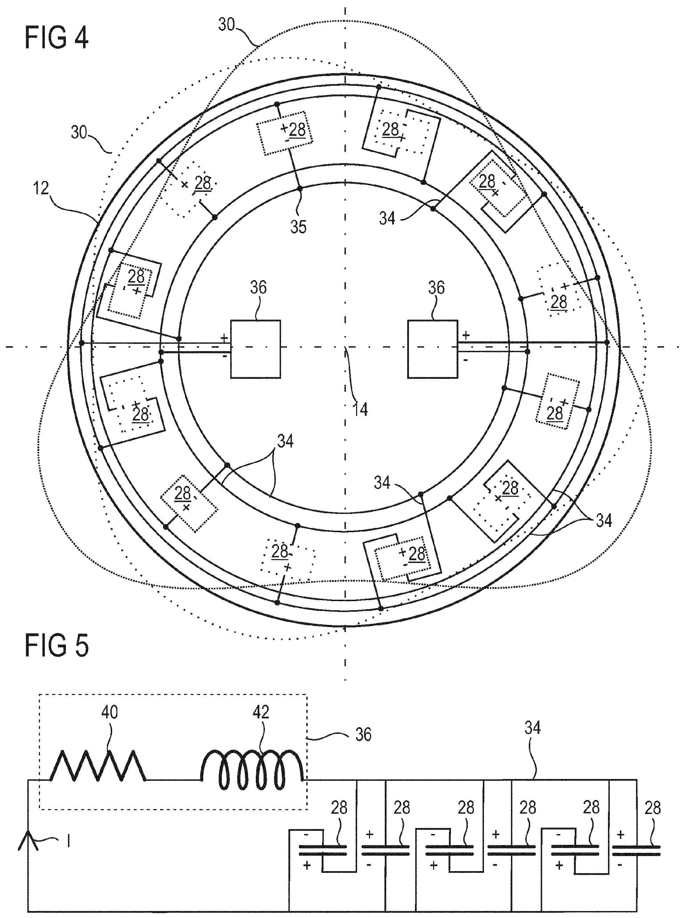

La figure 4 schématise un rotor 12 équipé du système amortisseur de vibrations basé sur l'utilisation de transducteurs piézoélectriques shuntés. L'invention prévoit de définir deux jeux de transducteurs piézoélectriques 28 grâce aux branchements. Chaque transducteur piézoélectrique a pour voisins directs, deux transducteurs piézoélectriques de l'autre jeu.

L'invention prévoit que les transducteurs piézoélectriques 28 d'un même jeu soient branchés électriquement entre eux. Pour pouvoir cumuler leurs énergies électriques, ils sont branchés en parallèle. Toutefois, pour chaque jeu, les deux transducteurs voisins directs d'un transducteur donné « X » seront soumis à des déformées en flexion de sens opposé audit transducteur « X ». Dès lors, certains transducteurs seront soumis à de la traction et d'autres à de la compression générant des courants de signes différents. Afin que les courants issus de chaque transducteur 28 d'un même jeu soient du même signe, la polarité de deux transducteurs voisins sera inversée. Cette inversion peut être réalisée à l'aide des branchements électriques, ou sur base de la polarité intrinsèque du matériau piézoélectrique que comprend le transducteur 28.

Les jeux de transducteurs piézoélectriques 28 sont branchés à l'aide de moyens de connexion 34 qui peuvent comprendre des fils ou des éléments structurants du rotor 12. Les moyens de connexion 34 des deux jeux pouvant être superposés, ils sont avantageusement isolés électriquement aux croisements ou sur toute leur longueur. Des raccordements électriques 35 sont réalisés entre les moyens de connexion 34 dédiés à un même transducteur piézoélectrique 28 et une branche collectrice. Cette dernière peut décrire un cercle sur le rotor.

Afin de dissiper l'énergie vibratoire du rotor 12 qui se présente sous forme mécanique, chaque jeu de transducteurs piézoélectriques 28 est raccordé à un circuit de dissipation d'énergie électrique 36 commun. Ce mode de raccordement permet de mutualiser un même circuit dissipatif 36 avec plusieurs transducteurs piézoélectriques 28. L'invention exploite la symétrie d'un mode à diamètre où les jeux de transducteurs piézoélectriques 28 sont chacun déformés de manière symétrique. Chaque jeu de transducteurs piézoélectriques 28 devient une source de courant cohérente par rapport à une déformation donnée.

La figure 5 illustre un circuit électrique de branchement des transducteurs piézoélectriques 28. Il forme un circuit fermé et matérialise un shunt des transducteurs piézoélectriques 28 à l'aide du circuit dissipatif 36. Le circuit dissipatif 36 comprend une résistance 40 pour dissiper l'énergie sous forme de chaleur, et une inductance 42 pour avoir une résonance du circuit fermé, permettant d'acheminer l'énergie dans le circuit. L'inductance peut être une bobine 42, préférentiellement analogique. On souligne qu'une bobine analogique est passive.

Le circuit dissipatif peut comprendre plusieurs résistances branchées en séries. Il peut également comprendre plusieurs inductances branchées en séries. Ces mêmes composants peuvent être intégrés dans le circuit fermé globalement, par exemple sur des moyens de connexion 34. Suivant une approche de l'invention, les moyens de connexion 34 peuvent présenter une résistance intrinsèque qui est exploitée pour dissiper de l'énergie.

La mise en parallèle des transducteurs piézoélectriques 28 peut être modélisée par la mise en parallèle de condensateurs de capacités C, qui agissent sur le circuit fermé comme un même condensateur de capacité équivalente unique, et égale à la somme des capacités individuelles puisque les transducteurs piézoélectriques 28 sont branchés en parallèle.

L'ensemble des transducteurs piézoélectriques 28 du jeu, la résistance 40 et la bobine 42 forment un circuit RLC résonant et amortissant. Sa fréquence d'amortissement $\omega_A$ est fonction de la capacité C du circuit et de son inductance L. Cette fréquence est celle pour laquelle le circuit agira efficacement comme amortisseur.

Elle est égale à :

$$\omega_A = \frac{1}{2*\pi*\sqrt{L*C}} \text{ (exprimée en Hz)}$$

Les niveaux vibratoires importants se produisent aux régimes de fonctionnement pour lesquels des résonances apparaissent entre l'excitation et les modes propres de la structure. L'utilisation d'amortisseurs est donc fondamentale à ces régimes.

Le choix des grandeurs des différents éléments du circuit fermé est régi par la nécessité d'égaler la fréquence de résonance du circuit électrique $\omega_A$ à celle du mode critique à amortir. Ainsi, le rotor 12, les transducteurs piézoélectriques 28 et le circuit dissipatif 36 forment un système électromécanique permettant une transformation d'énergie mécanique en énergie électrique ainsi qu'un transfert de cette énergie mécanique de la roue aubagée rotorique vers le circuit électrique permettant la dissipation énergétique.

L'invention facilite l'amortissement des modes propres basses fréquences à l'aide de circuits shuntés qui peuvent être totalement passifs. En effet, dans la formule précédente, la fréquence de résonance du circuit électrique, et donc d'amortissement, dépend de la capacité C du circuit. Plus cette capacité est importante, plus la valeur d'inductance nécessaire sera faible pour une fréquence donnée. Plus la valeur d'inductance est faible, plus la taille de la bobine sera petite et pourra donc être facilement intégrée sur la structure mécanique. En effet elle est un élément totalement analogique, par opposition à une inductance synthétique basée sur le principe du gyrator. L'invention permet ainsi un mode de réalisation totalement passif.

Pour un mode à N diamètres, le nombre de transducteurs piézoélectriques est de 4N répartis en deux jeux de 2N transducteurs connectés à leur circuit shunté propre. La mise en parallèle de 2N transducteurs permet donc, pour une fréquence de résonance donnée, de réduire la taille de l'inductance de chaque circuit d'un facteur 2N par rapport à un système amortisseur ou chaque transducteur est muni d'une inductance. De plus, seules deux inductances sont à présent nécessaires au lieu de 4N, ce qui correspond une nouvelle fois à une réduction de facteur 2N. Dès lors, au total, cette configuration permet de réduire la taille globale de l'inductance d'un facteur $4N^2$ pour une même efficacité.

## Revendications

1. Rotor (12), notamment de compresseur (4, 6), comprenant un système amortisseur de vibrations qui comporte au moins un jeu de transducteurs piézoélectriques (28) répartis circulairement sur le rotor et branchés à au moins un circuit dissipatif (36), **caractérisé en ce que** les transducteurs piézoélectriques (28) sont branchés de sorte à mutualiser le circuit dissipatif (36) ou chacun des circuits dissipatifs avec un jeu respectif d'au moins deux transducteurs branchés en parallèle, les transducteurs (28) du jeu ou de chacun des jeux étant répartis angulairement de manière homogène sur le rotor.

2. Rotor (12) selon la revendication 1, **caractérisé en ce qu'**il est apte à se déformer en vibration selon une déformée modale à diamètres, le nombre de transducteurs piézoélectriques (28) du jeu ou de chaque jeu étant égal au double du nombre de diamètre(s) de la déformée modale.

3. Rotor (12) selon la revendication 2, **caractérisé en ce que** la déformée modale à diamètres comprend essentiellement deux ondes de déformation (30) orthogonales avec des diamètres nodaux (32), les transducteurs piézoélectriques (28) étant répartis angulairement respectivement entre deux diamètres nodaux (32) adjacents des deux ondes de déformation (30).

4. Rotor (12) selon l'une des revendications 1 à 3, **caractérisé en ce que** le système amortisseur comprend plusieurs jeux d'au moins deux transducteurs (28) branchés en parallèle respectivement avec un des circuits dissipatifs (36), la polarité des branchements des transducteurs de chaque jeu étant telle que chacun desdits transducteurs (28) génère dans leur circuit dissipatif respectif (36) un courant de même signe lorsqu'ils sont déformés dans le même sens.

5. Rotor (12) selon l'une des revendications 1 à 3, **caractérisé en ce que** le système amortisseur ne comprend qu'un jeu d'au moins deux, préférentiellement au moins quatre transducteurs (28) branchés avec le circuit dissipatif (36), la polarité des branchements des transducteurs du jeu étant telle que chacun desdits transducteurs (28) génère dans ledit circuit dissipatif (36) un courant de même signe lorsqu'ils sont déformés dans le même sens.

6. Rotor (12) selon l'une des revendications 1 à 4, **caractérisé en ce que** le système amortisseur comprend deux jeux d'au moins deux transducteurs (28), lesdits jeux étant décalés angulairement de manière à ce que tous les transducteurs de tous les jeux soient répartis angulairement de manière homogène sur le rotor.

7. Rotor (12) selon l'une des revendications 1 à 6, **caractérisé en ce qu'**il est apte à se déformer en vibration selon une déformée modale à diamètres et que le système amortisseur comprend deux jeux de transducteurs piézoélectriques (28) qui sont déphasés l'un par rapport à l'autre d'une fraction de tour égale à l'inverse du quadruple du nombre de diamètre de ladite déformée modale à diamètres.

8. Rotor (12) selon l'une des revendications 1 à 7, **caractérisé en ce que** le ou au moins un des circuits dissipatifs (36) comprend au moins une inductance de manière à former un circuit résonant avec les transducteurs branchés en parallèle, le ou au moins un des circuits dissipatifs (36) formant préférentiellement essentiellement un circuit électrique fermé en combinaison avec les transducteurs piézoélectriques (28) du jeu correspondant.

9. Rotor (12) selon l'une des revendications 1 à 8, **caractérisé en ce que** le ou au moins un des circuits dissipatifs (36) est libre d'alimentation électrique extérieure.

10. Rotor (12) selon l'une des revendications 1 à 9, **caractérisé en ce qu'**il présente au moins une fréquence de résonance $\omega_R$, le circuit dissipatif (36) étant un circuit amortissant, préférentiellement résonant, dont la fréquence d'amortissement $\omega_A$ est égale à la fréquences de résonance $\omega_R$ du rotor (12) à amortir.

11. Rotor (12) selon l'une des revendications 1 à 10, **caractérisé en ce qu'**il est un disque aubagé ou un tambour aubagé.

12. Rotor (12) selon l'une des revendications 1 à 11, **caractérisé en ce qu'**au moins un des transducteurs piézoélectriques (28) est disposé sur une surface cylindrique ou sur une surface perpendiculaire à l'axe de rotation (14) du rotor, préférentiellement en dehors de la veine aérodynamique.

13. Rotor (12) selon l'une des revendications 1 à 12, **caractérisé en ce que** les transducteurs (28) sont disposés de manière à se déformer en traction-compression résultant de mouvement de flexion du rotor (12), préférentiellement suivant des déformations en flexion de l'enveloppe du rotor.

14. Turbomachine (2) comprenant un rotor (12), **caractérisée en ce que** le rotor (12) est conforme à l'une des revendications 1 à 13, préférentiellement le rotor est un rotor de compresseur (4, 6) ou de turbine (10).

15. Turbomachine (2) selon la revendication 14, **caractérisée en ce que** lors de son fonctionnement à un régime critique, le rotor (12) vibre à une fréquence de résonance suivant un mode à diamètres, le nombre de transducteurs piézoélectriques (28) de chaque jeu étant supérieur ou égal à deux fois le nombre de diamètres (32), préférentiellement égal à quatre fois le nombre de diamètres (32) du mode de résonance.

**Patentansprüche**

1. Rotor (12), insbesondere eines Kompressors (4, 6), mit einem Vibrationsdämpfungssystem, das mindestens einen Satz piezolektrische Transducer (28) beinhaltet, die kreisförmig auf dem Rotor verteilt und an mindestens einen dissipativen Schaltkreis (36) angeschlossen sind,
   **dadurch gekennzeichnet, dass**
   die piezoelektrischen Transducer (28) so angeschlossen sind, dass sie den dissipativen Schaltkreis (36) oder jeden der dissipativen Schaltkreise mit einem jeweiligen Satz aus mindestens zwei parallel angeschlossenen Transducern gemeinsam nutzen, wobei die Transducer (28) des Satzes oder jedes der Sätze winkelbezogen gleichmäßig auf dem Rotor verteilt sind.

2. Rotor (12) nach Anspruch 1, **dadurch gekennzeichnet, dass** er in der Lage ist, sich bei Vibrationen entsprechend einer Schwingungsform mit Durchmessern zu verformen, wobei die Anzahl der piezoleketrischen Transducer (28) des Satzes oder jedes Satzes dem Zweifachen der Anzahl der Durchmesser der Schwingungsform entspricht.

3. Rotor (12) nach Anspruch 2, **dadurch gekennzeichnet, dass** die Schwingungsform mit Durchmessern im Wesentlichen zwei orthogonale Verformungswellen (30) mit nodalen Durchmessern (32) beinhaltet, wobei die piezoelektrischen Transducer (28) winkelbezogen jeweils zwischen zwei benachbarten nodalen Durchmessern (32) der beiden Verformungswellen (30) verteilt sind.

4. Rotor (12) nach einem der Ansprüche 1 bis 3, **dadurch gekennzeichnet, dass** das Dämpfungssystem mehrere Sätze aus mindestens zwei Transducern (28) beinhaltet, die parallel jeweils mit einem der dissipativen Schaltkreise verbunden sind, wobei die Polarität der Anschlüsse der Transducer an jeden Satz so geartet ist, dass jeder der genannten Transducer (28) im seinem jeweiligen dissipativen Schaltkreis (36) einen Strom mit dem gleichen Vorzeichen erzeugt, wenn sie in gleicher Richtung verformt werden.

5. Rotor (12) nach einem der Ansprüche 1 bis 3, **dadurch gekennzeichnet, dass** das Dämpfungssystem nur einen Satz aus mindestens zwei, vorzugsweise vier Transducern (28) beinhaltet, die an den dissipativen Schaltkreis (36) angeschlossen sind, wobei die Polarität der Anschlüsse der Transducer des Satzes so geartet ist, dass jeder der genannten Transducer (28) im gleichen dissipativen Schaltkreis (36) einen Strom mit dem gleichen Vorzeichen erzeugt, wenn sie in der gleichen Richtung verformt werden.

6. Rotor (12) nach einem der Ansprüche 1 bis 4, **dadurch gekennzeichnet, dass** das Dämpfungssystem mindestens zwei Sätze von Transducern (28) beinhaltet, wobei die genannten Sätze winkelbezogen so angeordnet sind, dass alle Transducer der Sätze winkelbezogen gleichmäßig auf dem Rotor verteilt sind.

7. Rotor (12) nach einem der Ansprüche 1 bis 6, **dadurch gekennzeichnet, dass** er in der Lage ist, sich unter Vibrationen anhand einer Schwingungsform mit Durchmessern zu verformen und dass das Dämpfungssystem zwei Sätze von piezoelektrischen Transducern (28) beinhaltet, die im Verhältnis zueinander um einen Bruchteil der Umdrehung versetzt sind, der dem umgekehrten Vierfachen der Anzahl der Durchmesser der genannten Schwingungsform mit Durchmessern entspricht.

8. Rotor nach einem der Ansprüche 1 bis 7, **dadurch gekennzeichnet, dass** der oder mindestens einer der dissipativen Schaltkreise (36) mindestens eine Drosselspule beinhaltet, um mit den parallel angeschlossenen Transducern eine Resonanzschaltung zu bilden, wobei der oder mindestens einer der dissipativen Schaltkreise (36) vorzugsweise und im Wesentlichen einen geschlossenen elektrischen Schaltkreis in Kombination mit den piezoelektrischen Transducern (28) des entsprechenden Satzes bildet.

9. Rotor (12) nach einem der Ansprüche 1 bis 8, **da-**

durch gekennzeichnet, dass der oder mindestens einer der dissipativen Schaltkreise (36) frei von einer externen Stromversorgung ist.

10. Rotor (12) nach einem der Ansprüche 1 bis 9, dadurch gekennzeichnet, dass er mindestens eine Resonanzfrequenz WR aufweist, wobei der dissipative Schaltkreis (36) ein Dämpfungskreis und vorzugsweise Resonanzkreis ist, dessen Dämpfungsfrequenz WA der Resonanzfrequenz WE des zu dämpfenden Rotors (12) entspricht.

11. Rotor (12) nach einem der Ansprüche 1 bis 10, dadurch gekennzeichnet, dass er eine Schaufelscheibe oder eine Schaufeltrommel ist.

12. Rotor (12) nach einem der Ansprüche 1 bis 11, dadurch gekennzeichnet, dass mindestens einer der piezoelektrischen Transducer (28) auf einer zylindrischen Oberfläche oder auf einer rechtwinklig zur Rotationsachse (14) des Rotors verlaufenden Oberfläche und vorzugsweise außerhalb der aerodynamischen Strömung angeordnet ist.

13. Rotor (13) nach einem der Ansprüche 1 bis 12, dadurch gekennzeichnet, dass die Transducer (28) so angeordnet sind, dass sie sich unter Zug-Druck infolge der Flexionsbewegung des Rotors (12) verformen, vorzugsweise indem sie den Flexionsverformungen der Rotorhülle folgen.

14. Turbomaschine (2) mit einem Rotor (12), dadurch gekennzeichnet, dass der Rotor (12) einem der Ansprüche 1 bis 13 entspricht, wobei der Rotor vorzugsweise ein Kompressor- (4, 6) oder Turbinenrotor (10) ist.

15. Turbomaschine (2) nach Anspruch 14, dadurch gekennzeichnet, dass bei einem Betrieb mit einer kritischen Drehzahl der Rotor (12) mit einer Resonanzfrequenz entsprechend einer Schwingungsform vibriert, wobei die Anzahl der piezoelektrischen Transducer (28) jedes Satzes höher ist oder dem Zweifachen der Anzahl der Durchmesser (32), vorzugsweise aber dem Vierfachen der Anzahl der Durchmesser (32) des Resonanzmodus entspricht

**Claims**

1. Rotor (12), in particular of a compressor (4, 6), comprising a vibration-damping system which comprises at least one set of piezoelectric transducers (28) distributed circularly over the rotor and connected to at least one dissipative circuit (36), **characterized in that** the piezoelectric transducers (28) are connected so as to pool the dissipative circuit (36) or each of the dissipative circuits with a respective set of at least two transducers connected in parallel, the transducers (28) of the set or of each of the sets being angularly distributed homogeneously over the rotor.

2. Rotor (12) according to Claim 1, **characterized in that** it is able to deform under vibration in accordance with a modal shape with diameters, the number of piezoelectric transducers (28) of the set or of each set being equal to twice the number of diameter(s) of the modal shape.

3. Rotor (12) according to Claim 2, **characterized in that** the modal shape with diameters basically comprises two orthogonal deformation waves (30) with nodal diameters (32), the piezoelectric transducers (28) being angularly distributed in each case between two adjacent nodal diameters (32) of the two deformation waves (30).

4. Rotor (12) according to one of Claims 1 to 3, **characterized in that** the vibration-damping system comprises a plurality of sets of at least two transducers (28) connected in parallel with a respective one of the dissipative circuits (36), the polarity of the connections of transducers of each set being such that each of said transducers (28) generates, in the respective dissipative circuit (36) thereof, a current of identical sign when said transducers are deformed in the same direction.

5. Rotor (12) according to one of Claims 1 to 3, **characterized in that** the damper system comprises only one set of at least two, preferably at least four, transducers (28) connected to the dissipative circuit (36), the polarity of the connections of the transducers of the set being such that each of said transducer (28) generates in said dissipative circuit (36) a current of identical sign when said transducers are deformed in the same direction.

6. Rotor (12) according to one of Claims 1 to 4, **characterized in that** the vibration-damping system comprises two sets of at least two transducers (28), said sets being angularly offset in such a way that all the transducers of all the sets are angularly distributed homogeneously over the rotor.

7. Rotor (12) according to one of Claims 1 to 6, **characterized in that** it is able to deform under vibration in accordance with a modal shape with diameters, and **in that** the vibration-damping system comprises two sets of piezoelectric transducers (28), which are out of phase in relation to one another by a fraction of revolution equal to the inverse of the quadruple of the number of diameters of said modal shape with diameters.

**8.** Rotor (12) according to one of Claims 1 to 7, **characterized in that** the dissipative circuit or at least one of the dissipative circuits (36) comprises at least one inductor so as to form a resonant circuit with the transducers connected in parallel, the dissipative circuit or at least one of the dissipative circuits (36) preferably basically forming a closed electric circuit in combination with the piezoelectric transducers (28) of the corresponding set.

**9.** Rotor (12) according to one of Claims 1 to 8, **characterized in that** the dissipative circuit or at least one of the dissipative circuits (36) is free from external electrical supply.

**10.** Rotor (12) according to one of Claims 1 to 9, **characterized in that** it has at least one resonance frequency $\omega_R$, the dissipative circuit (36) being a damping circuit, preferably a resonant circuit, of which the damping frequency $\omega_A$ is equal to the resonance frequency $\omega_R$ of the rotor (12) to be damped.

**11.** Rotor (12) according to one of Claims 1 to 10, **characterized in that** it is a bladed disk or a bladed drum.

**12.** Rotor (12) according to one of Claims 1 to 11, **characterized in that** at least one of the piezoelectric transducers (28) is disposed on a cylindrical surface or on a surface perpendicular to the axis of rotation (14) of the rotor, preferably outside the aerodynamic flow.

**13.** Rotor (12) according to one of Claims 1 to 12, **characterized in that** the transducers (28) are disposed so as to deform under tension/compression resulting from the flexural movement of the rotor (12), preferably following flexural deformations of the casing of the rotor.

**14.** Turbomachine (2) comprising a rotor (12), **characterized in that** the rotor (12) is formed according to one of Claims 1 to 13, the rotor preferably being a rotor of a compressor (4, 6) or of a turbine (10).

**15.** Turbomachine (2) according to Claim 14, **characterized in that**, during operation at a critical speed, the rotor (12) vibrates at a resonance frequency in accordance with a mode with diameters, the number of piezoelectric transducers (28) of each set being greater than or equal to twice the number of diameters (32), preferably equal to four times the number of diameters (32), of the resonance mode.

FIG 1

FIG 2

FIG 3

**FIG 4**

**FIG 5**

**EP 2 860 405 B1**

## RÉFÉRENCES CITÉES DANS LA DESCRIPTION

**Documents brevets cités dans la description**

- JP 19960861295 B